# EUROPEAN PATENT APPLICATION

(11) **EP 3 660 895 A1**
(43) Date of publication of application: **03.06.2020**
(21) Application number: 18838105.7
(22) Date of filing: 24.07.2018
(51) Int. Cl.: H01L 23/373

(54) **HEAT DISSIPATING ELEMENT AND PREPARATION METHOD THEREFOR, AND IGBT MODULE**

(30) Priority: 27.07.2017 CN 201710624655
(71) Applicant: BYD Company Limited, Shenzhen, Guangdong 518118 (CN)
(72) Inventor: LIU, Chengchen, Shenzhen Guangdong 518118 (CN); XU, Qiang, Shenzhen Guangdong 518118 (CN); LIN, Xinping, Shenzhen Guangdong 518118 (CN)
(74) Representative: Gulde & Partner
(86) International application number: PCT/CN2018/096827
(87) International publication number: WO 2019/020015

(57) **Abstract**

The present disclosure relates to a heat dissipation element, a method for manufacturing the heat dissipation element, and an IGBT module. The heat dissipation element includes a heat conductor and a heat dissipation body; the heat conductor is a ceramic-coated aluminum copper heat conductor; the heat dissipation body is an aluminum silicon carbon heat dissipation body; the ceramic-coated aluminum copper heat conductor includes a ceramic insulating plate, a copper layer, and a first aluminum layer and a second aluminum layer that are located on two opposite surfaces of the ceramic insulating plate, where the first aluminum layer and the second aluminum layer are isolated by the ceramic insulating plate, and the copper layer is bonded to the ceramic insulating plate by using the second aluminum layer that is integrally formed through aluminizing; the ceramic insulating plate is bonded to the aluminum silicon carbon heat dissipation body by using the first aluminum layer that is integrally formed through aluminizing; and the IGBT module includes the foregoing heat dissipation element.

## Description

### FIELD

The present disclosure relates to the technical field of heat sinks, and in particular, to a heat dissipation element, a method for manufacturing the heat dissipation element, and an IGBT module.

### BACKGROUND

An insulated gate bipolar transistor (IGBT) is a composite full-controlled voltage-driven power semiconductor device including a bipolar transistor and an insulated gate field effect transistor, and is widely applied to various electronic devices. With the development of high-current electronic devices such as a converter, higher requirements are put forward on performance of an IGBT chip. The IGBT chip bears a higher current, and heat generated during operating of the IGBT chip continuously increases. Current direct packaging of the IGBT chip uses a vacuum welding technology. A packaging process totally includes three processes: manufacturing of a ceramic-coated aluminum copper heat conductor, processing on an aluminum silicon carbon heat dissipation body, and welding between the ceramic-coated aluminum copper heat conductor and the aluminum silicon carbon heat dissipation body. The vacuum welding technology is complex and has a long production period. Moreover, bubbles generated in a welding process or an uneven solder layer may result in that voids having different shapes and sizes are formed at a welding layer. The voids in the welding layer may cause a current density effect, resulting in thermoelectric breakdown, poor heat conduction, and the like. Consequently, a packaging yield rate thereof decreases, and a service life is shortened.

Therefore, a new heat dissipation apparatus is urgently required to overcome the defects of vacuum welding in the prior art, to obtain a heat dissipation apparatus having a better heat conduction effect.

### SUMMARY

An objective of the present disclosure is to provide a heat dissipation element. The heat dissipation element has a good heat conduction effect, a simple structure, and a low processing difficulty.

To achieve the foregoing objective, the present disclosure provides a heat dissipation element. The heat dissipation element includes a heat conductor and a heat dissipation body; the heat conductor is a ceramic-coated aluminum copper heat conductor; the heat dissipation body is an aluminum silicon carbon heat dissipation body; the ceramic-coated aluminum copper heat conductor includes a ceramic insulating plate, a copper layer, and a first aluminum layer and a second aluminum layer that are located on two opposite surfaces of the ceramic insulating plate, where the first aluminum layer and the second aluminum layer are isolated by the ceramic insulating plate, and the copper layer is bonded to the ceramic insulating plate by using the second aluminum layer that is integrally formed through aluminizing; and the ceramic insulating plate is bonded to the aluminum silicon carbon heat dissipation body by using the first aluminum layer that is integrally formed through aluminizing.

In the foregoing technical solution, compared with a heat dissipation element obtained through vacuum welding, the heat dissipation element described in the present disclosure has fewer voids at a metal layer, higher strength, and a higher yield rate, and a service life is extended; the heat dissipation element has a thinner aluminum layer, thereby improving heat conduction efficiency of the heat dissipation element; there is no gap on bonding surfaces between layers of the heat dissipation element provided in the present disclosure, thereby having higher connection strength and higher heat conduction efficiency; in addition, a relatively soft aluminum layer provides the heat dissipation apparatus with more excellent performance in coldness and heat impact tolerance; meanwhile, compared with aluminum, the copper layer of the heat dissipation element in the present disclosure has higher heat conduction efficiency, strengthens supporting of the heat conductor for elements of an electronic device, reinforces structural strength of the heat conductor, and extends the service life.

The present disclosure further provides a method for manufacturing a heat dissipation element. The method includes the following steps:

S1. Mount a silicon carbide porous skeleton, a ceramic insulating plate, and a copper layer into a mold, and enable a first slot to exist between the silicon carbide porous skeleton and the ceramic insulating plate, and a second slot to exist between the ceramic insulating plate and the copper layer.

S2. Under pressure casting infiltration conditions, add molten aluminum liquid into the preheated mold, filling, with the molten aluminum liquid, the first slot, the second slot, and the silicon carbide porous skeleton, perform operations of vacuum pumping and pressurizing, and then perform cooling and demolding.

S3. Form an aluminum silicon carbon heat dissipation body after at least the surface of the silicon carbide porous skeleton is filled with aluminum, and remove a part of aluminum metal in the first slot and the second slot by etching, so that remaining aluminum metal in the first slot forms a first aluminum layer and remaining aluminum metal in the second slot forms a second aluminum layer; alternatively, remove a part of aluminum metal in the second slot by etching, so that remaining aluminum metal in the second slot forms a second aluminum layer; and the second aluminum layer and the first aluminum layer are isolated by the ceramic insulating plate, and the second aluminum layer and the aluminum silicon carbon heat dissipation body are isolated.

In the foregoing technical solution, according to the method for manufacturing the heat dissipation element provided in the present disclosure, molten aluminum liquid or aluminum alloy liquid is integrally formed to produce a ceramic-coated aluminum copper heat conductor, and the ceramic-coated aluminum copper heat conductor is connected to an aluminum silicon carbon heat dissipation body. Three steps in a vacuum welding technology including manufacturing of the ceramic-coated aluminum copper heat conductor, processing on the aluminum silicon carbon heat dissipation body, and welding between the ceramic-coated aluminum copper heat conductor and the aluminum silicon carbon heat dissipation body are combined into one step, thereby shortening a production period of the heat dissipation element; meanwhile, an integral forming manner is adopted, thereby improving structural strength and impact tolerance performance of the heat dissipation element, and extending a service life.

The present disclosure further provides a heat dissipation element manufactured by using the foregoing method.

The present disclosure further provides an IGBT module. The IGBT module includes an IGBT circuit board and the heat dissipation element described above.

Other features and advantages of the present disclosure are described in detail in subsequent specific implementations.

### BRIEF DESCRIPTION OF THE DRAWINGS

The accompanying drawings are used to provide a further understanding of the present disclosure, and constitute a part of the specification. The accompanying drawings are used, along with the following specific implementations, to explain the present disclosure, but do not constitute any limitation on the present disclosure. In the drawings:
FIG. 1 is a sectional view of a structure of a heat dissipation element without a groove;
FIG. 2 is a sectional view of a structure of a heat dissipation element with a groove; and
FIG. 3 is a sectional view of an internal structure of a mold of a heat dissipation element with a groove.

### Reference numerals:

| | | | | |
|---|---|---|---|---|
| | 1 | Aluminum silicon carbon heat dissipation body | 2 | Ceramic insulating plate |
| | 3 | First aluminum layer | 4 | Second aluminum layer |
| | 5 | Heat dissipation column | 6 | Copper layer |
| | 7 | Groove | 8 | First slot |
| | 9 | Second slot | 10 | Third slot |
| | 11 | Mold | 12 | Silicon carbide porous skeleton |

### DETAILED DESCRIPTION

The following describes specific implementations of the present disclosure in detail with reference to the accompanying drawings. It should be understood that the specific implementations described herein are merely used to describe and explain the present disclosure, but are not intended to limit the present disclosure.

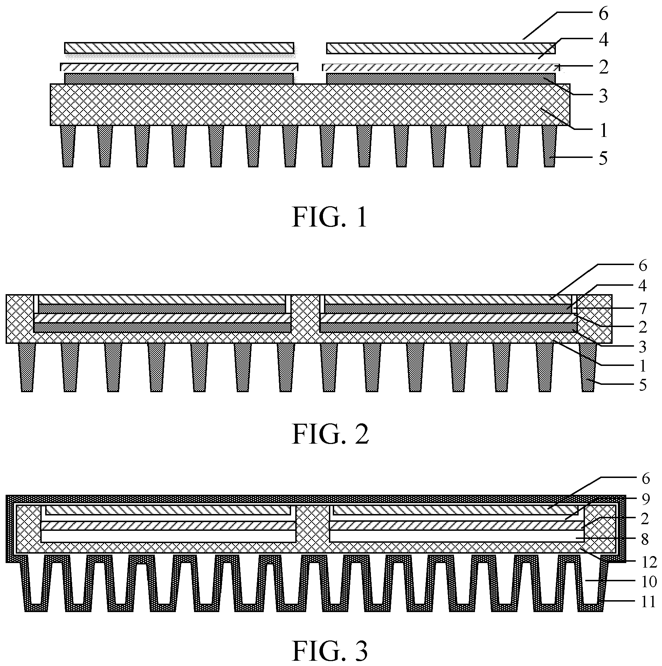

A first aspect of the present disclosure provides a heat dissipation element. As shown in FIG. 1, the heat dissipation element includes a heat conductor and a heat dissipation body, and the heat conductor is a ceramic-coated aluminum copper heat conductor; the heat dissipation body is an aluminum silicon carbon heat dissipation body 1; the ceramic-coated aluminum copper heat conductor includes a ceramic insulating plate 2, a copper layer 6, and a first aluminum layer 3 and a second aluminum layer 4 that are located on two opposite surfaces of the ceramic insulating plate 2, where the first aluminum layer 3 and the second aluminum layer 4 are isolated by the ceramic insulating plate 2, and the copper layer 6 is bonded to the ceramic insulating plate 2 by using the second aluminum layer 4 that is integrally formed through aluminizing; and the ceramic insulating plate 2 is bonded to the aluminum silicon carbon heat dissipation body 1 by using the first aluminum layer 3 that is integrally formed through aluminizing.

In the foregoing technical solution, compared with a heat dissipation element obtained through vacuum welding, the heat dissipation element described in the present disclosure has fewer voids at a metal layer, higher strength, and a higher yield rate, and a service life is extended; the heat dissipation element has a thinner aluminum layer, thereby improving heat conduction efficiency of the heat dissipation element; there is no gap on bonding surfaces between layers of the heat dissipation element provided in the present disclosure, thereby having higher connection strength and higher heat conduction efficiency; in addition, a relatively soft aluminum layer provides the heat dissipation apparatus with more excellent performance in coldness and heat impact tolerance; meanwhile, compared with aluminum, the copper layer 6 of the heat dissipation element in the present disclosure has higher heat conduction efficiency, strengthens supporting of the heat conductor for elements of an electronic device, reinforces structural strength of the heat conductor, and extends the service life.

According to the first aspect of the present disclosure, preferably, the ceramic insulating plate 2 is an alumina ceramic plate, a toughened alumina ceramic plate, an aluminum nitride ceramic plate, or a silicon nitride ceramic plate. Ceramic plates made of the foregoing materials have relatively low density and relatively high hardness, thereby helping extend a service life. The ceramic insulating plate 2 achieves an insulation effect by isolating the first aluminum layer 3 from the second aluminum layer 4.

According to the first aspect of the present disclosure, there are at least two ceramic-coated aluminum copper heat conductors disposed at an interval, and each of the ceramic-coated aluminum copper heat conductors is bonded to the aluminum silicon carbon heat dissipation body 1 by using the first aluminum layer 3 that is integrally formed through aluminizing. Preferably, one or more ceramic-coated aluminum copper heat conductors are bonded to the aluminum silicon carbon heat dissipation body 1 by using the first aluminum layer 3 that is integrally formed through aluminizing; the plurality of ceramic-coated aluminum copper heat conductors are spaced apart from each other; intervals between the plurality of ceramic-coated aluminum copper heat conductors may be freely set according to a requirement, and this is not specifically required in the present disclosure; in addition, relative to a same aluminum silicon carbon heat dissipation body 1, there are a plurality of manners for disposing the ceramic insulating plate 2, the first aluminum layer 3, and the second aluminum layer 4: for example, one ceramic insulating plate 2 may be disposed, and there are one first aluminum layer 3 and one or more second aluminum layers 4, where the plurality of second aluminum layers 4 are spaced apart from each other; alternatively, there are a plurality of ceramic insulating plates 2, and a quantity of first aluminum layers 3 and a quantity of second aluminum layers 4 are the same as a quantity of the ceramic insulating plates 2. Different settings of the ceramic insulating plate 2, the first aluminum layer 3 and the second aluminum layer 4 can satisfy different requirements for heat dissipation design.

According to the first aspect of the present disclosure, preferably, the aluminum silicon carbon heat dissipation body 1 is a silicon carbide porous skeleton 12 whose surface and interior contain aluminum, and the aluminum is bonded to the surface and the interior of the silicon carbide porous skeleton 12 through aluminizing in an integral forming manner. In other words, the aluminum silicon carbon heat dissipation body 1 includes the silicon carbide porous skeleton 12 and the aluminum bonded to the surface and the interior of the silicon carbide porous skeleton 12 through aluminizing in an integral forming manner; and the silicon carbide porous skeleton 12 may integrally reinforce, along with the aluminum, structural strength of the aluminum silicon carbon heat dissipation body 1 and connection strength of other components.

According to the first aspect of the present disclosure, preferably, the first aluminum layer 3 and the second aluminum layer 4 may each be a pure aluminum layer or an aluminum alloy layer; a thickness of the first aluminum layer 3 is 0.02 to 0.15 mm, a thickness of the ceramic insulating plate 2 is 0.25 to 1 mm, a thickness of the second aluminum layer 4 is 0.02 to 0.15 mm, and a thickness of the copper layer 6 is 0.2 to 0.6 mm. The aluminum layer and the aluminum alloy layer can both satisfy heat conduction design of the heat dissipation apparatus, and the aluminum layer and the aluminum alloy layer have relatively low hardness and more excellent performance in coldness and heat impact tolerance. Therefore, use of the aluminum layer, the copper layer 6, and the ceramic insulating plate 2 of the described thicknesses may improve efficiency and structural strength of the ceramic-coated aluminum copper heat conductor, and extend a service life.

According to the first aspect of the present disclosure, as a preferred implementation of the present disclosure, a surface, connected to the first aluminum layer 3, of the aluminum silicon carbon heat dissipation body 1 is a flat surface; and the ceramic-coated aluminum copper heat conductor protrudes on the flat surface of the aluminum silicon carbon heat dissipation body 1.

According to the first aspect of the present disclosure, as another preferred implementation of the present disclosure, as shown in FIG. 2, the aluminum silicon carbon heat dissipation body 1 is provided with one or more grooves 7; the ceramic-coated aluminum copper heat conductor is embedded into the groove 7; the foregoing aluminum silicon carbon heat dissipation body 1 provided with the groove 7 is used, and the ceramic-coated aluminum copper heat conductor is embedded into the groove 7 through aluminizing in an integral forming manner, thereby avoiding a case in which an edge of a pasted film cracks during etching to affect an etching pattern, improving accuracy of etching, and improving strength and stability of the heat dissipation element.

The operation of providing the aluminum silicon carbon heat dissipation body 1 with one or more grooves 7 may be implemented by using computer numerical control (CNC) machine tools.

According to the first aspect of the present disclosure, preferably, the ceramic-coated aluminum copper heat conductor is embedded into the groove 7, so that an upper surface of the copper layer 6 is flush with an upper surface of the aluminum silicon carbon heat dissipation body 1. In other words, the upper surface of the copper layer 6 and the upper surface, except the groove 7, of the aluminum silicon carbon heat dissipation body 1 form a flat surface; and the formed flat surface is conducive to pasting a film during subsequent etching, and prevents the pasted film from cracking, and etching is performed according to a presetting to improve the accuracy of etching.

According to the first aspect of the present disclosure, preferably, as shown in FIG. 1 and FIG. 2, the aluminum silicon carbon heat dissipation body 1 is further provided with at least one heat dissipation column 5; and one end of the heat dissipation column 5 is fixedly connected to the aluminum silicon carbon heat dissipation body 1, and the other end of the heat dissipation column 5 is a free end. The heat dissipation column 5 is disposed on a surface, opposite to one side of the ceramic-coated aluminum copper heat conductor, of the aluminum silicon carbon heat dissipation body 1. The heat dissipation column 5 can conduct heat radiated by an IGBT module, to improve heat dissipation efficiency.

According to the first aspect of the present disclosure, preferably, the heat dissipation column 5 is at least one of an aluminum column, an aluminum alloy column, and an aluminum-coated copper column; the heat dissipation column 5 is connected to the aluminum silicon carbon heat dissipation body 1 in an integral forming manner; and connection strength between the integrally formed heat dissipation column 5 and the aluminum silicon carbon heat dissipation body 1 is higher, thereby extending a service life of the heat dissipation apparatus.

A second aspect of the present disclosure provides a method for manufacturing a heat dissipation element. As shown in FIG. 3, the method includes the following steps:

S1. Mount a silicon carbide porous skeleton 12, a ceramic insulating plate 2, and a copper layer 6 into a mold 11, and enable a first slot 8 to exist between the silicon carbide porous skeleton 12 and the ceramic insulating plate 2, and a second slot 9 to exist between the ceramic insulating plate 2 and the copper layer 6.

S2. Under pressure casting infiltration conditions, add molten aluminum liquid into the preheated mold 11, fill, with the molten aluminum liquid, the first slot 8, the second slot 9, and the silicon carbide porous skeleton 12, perform operations of vacuum pumping and pressurizing, and then perform cooling and demolding.

S3. Form an aluminum silicon carbon heat dissipation body 1 after at least the surface of the silicon carbide porous skeleton 12 is filled with aluminum, and remove a part of aluminum metal in the first slot 8 and the second slot 9 by etching, so that remaining aluminum metal in the first slot 8 forms a first aluminum layer 3 and remaining aluminum metal in the second slot 9 forms a second aluminum layer 4; alternatively, remove a part of aluminum metal in the second slot 9 by etching, so that remaining aluminum metal in the second slot 9 forms a second aluminum layer 4; and the second aluminum layer 4 and the first aluminum layer 3 are isolated by the ceramic insulating plate 2, and the second aluminum layer 4 and the aluminum silicon carbon heat dissipation body 1 are isolated.

In the foregoing technical solution, according to the method for manufacturing the heat dissipation element provided in the foregoing technical solution, molten aluminum liquid or aluminum alloy liquid is integrally formed to produce the ceramic-coated aluminum copper heat conductor, and the ceramic-coated aluminum copper heat conductor is connected to the aluminum silicon carbon heat dissipation body 1. Three steps in a vacuum welding technology including manufacturing of the ceramic-coated aluminum copper heat conductor, processing on the aluminum silicon carbon heat dissipation body 1, and welding between the ceramic-coated aluminum copper heat conductor and the aluminum silicon carbon heat dissipation body 1 are combined into one step, thereby shortening a production period of the heat dissipation element; meanwhile, an integral forming manner is adopted, thereby improving structural strength and impact tolerance performance of the heat dissipation element, and extending a service life.

According to the second aspect of the present disclosure, preferably, the pressure casting infiltration conditions include: a temperature of the preheating is 500 to 700°C, a temperature of the molten aluminum liquid is 500 to 700°C, a pressure of the vacuum pumping is 50 to 100 Pa, a pressure of the pressurizing is 4 to 10 MPa, and the molten aluminum liquid is pure aluminum or aluminum alloy. Pressure aluminizing in an integral forming manner under the conditions can reduce voids in the first aluminum layer 3, the second aluminum layer 4, and a metal layer of the heat dissipation column 5, thereby improving production quality and a yield rate.

According to the second aspect of the present disclosure, preferably, at least one column-shaped recess 10 protruding outward is formed on an inner surface of the mold 11, and the column-shaped recess 10 is suitable for forming at least one heat dissipation column 5 connected to the silicon carbide porous skeleton 12. In other words, a third slot 10 further exists between the silicon carbide porous skeleton 12 and a wall of the mold 11. The third slot 10 is used to form the heat dissipation column 5. In the method, the heat dissipation column 5 may form connection with the aluminum silicon carbon heat dissipation body 1 in a one-time manner, thereby avoiding subsequent melding of the heat dissipation column 5, and improving stability of the connection between the heat dissipation column 5 and the aluminum silicon carbon heat dissipation body 1. The third slot 10 may be comb-tooth-shaped, and the tooth-shaped protrusion is used to form the heat dissipation column 5.

According to the second aspect of the present disclosure, preferably, relative to a same aluminum-silicon-carbon heat dissipation body 1, there may be one or more or at least two ceramic insulating plates 2. The plurality of ceramic insulating plates 2 are spaced apart from each other. Relative to a same aluminum silicon carbon heat dissipation body 1, there are a plurality of manners for disposing the ceramic insulating plate 2, the first aluminum layer 3, and the second aluminum layer 4: for example, one ceramic insulating plate 2 may be disposed, and there are one first aluminum layer 3 and one or more second aluminum layers 4, where the plurality of second aluminum layers 4 are connected to the ceramic insulating plate 2 and are spaced apart from each other; alternatively, there are a plurality of ceramic insulating plates 2, and a quantity of first aluminum layers 3 and a quantity of second aluminum layers 4 are the same as a quantity of the ceramic insulating plates 2. Different settings of the ceramic insulating plate 2, the first aluminum layer 3 and the second aluminum layer 4 can satisfy different requirements for heat dissipation design.

According to the second aspect of the present disclosure, as a preferred implementation of the present disclosure, a surface, connected to the first aluminum layer 3, of the aluminum silicon carbon heat dissipation body 1 is a flat surface; and the ceramic-coated aluminum copper heat conductor protrudes on the flat surface of the aluminum silicon carbon heat dissipation body 1. In this case, a part of aluminum metal in the first slot 8 and the second slot 9 needs to be removed by etching, so that the remaining aluminum metal in the first slot 8 forms the first aluminum layer 3, and the remaining aluminum metal in the second slot 9 forms the second aluminum layer 4.

According to the second aspect of the present disclosure, as another preferred implementation of the present disclosure, the silicon carbide porous skeleton 12 is provided with at least one groove 7, and the ceramic insulating plate 2 and the copper layer 6 are horizontally disposed inside the groove 7 in sequence; in addition, there is the first slot 8 between the silicon carbide porous skeleton 12 and the ceramic insulating plate 2, and there is the second slot 9 between the ceramic insulating plate 2 and the copper layer 6. In other words, the aluminum silicon carbon heat dissipation body 1 is provided with one or more grooves 7; the ceramic-coated aluminum copper heat conductor is embedded into the groove 7; the foregoing aluminum silicon carbon heat dissipation body 1 provided with the groove 7 is used, and the ceramic-coated aluminum copper heat conductor is embedded into the groove 7 through aluminizing in an integral forming manner, thereby avoiding a case in which an edge of a pasted film cracks during etching to affect an etching pattern, improving accuracy of etching, and improving strength and stability of the heat dissipation element. In this case, a part of aluminum metal in the second slot 9 is removed by etching, so that the remaining aluminum metal in the second slot 9 forms the second aluminum layer 4.

The operation of providing the aluminum silicon carbon heat dissipation body 1 with one or more grooves 7 may be implemented by using computer numerical control (CNC) machine tools.

According to the second aspect of the present disclosure, preferably, an upper surface of the copper layer 6 and an upper surface, except the groove 7, of the aluminum silicon carbon heat dissipation body 1 form a flat surface; and the formed flat surface is conducive to pasting a film during subsequent etching, and prevents the pasted film from cracking, and etching is performed according to a presetting to improve the accuracy of etching.

According to the second aspect of the present disclosure, preferably, the ceramic insulating plate 2 is an alumina ceramic plate, a toughened alumina ceramic plate, an aluminum nitride ceramic plate, or a silicon nitride ceramic plate; a thickness of the first aluminum layer 3 is 0.02 to 0.15 mm, a thickness of the ceramic insulating plate 2 is 0.25 to 1 mm, a thickness of the second aluminum layer 4 is 0.02 to 0.15 mm, and a thickness of the copper layer 6 is 0.2 to 0.6 mm. Ceramic plates made of the foregoing materials have relatively low density and relatively high hardness, thereby helping extend a service life. Use of an aluminum layer with the described thickness and the ceramic insulating plate 2 can improve heat conduction efficiency and structural strength of the ceramic-coated aluminum copper heat conductor, and extend the service life.

According to the second aspect of the present disclosure, preferably, etching may be performed by using various methods generally used by a person skilled in the art. A parameter may be a generally used parameter. For example, an etching operation includes sequentially performed steps of pasting a film, exposing, developing, corroding, removing the film, and washing.

A third aspect of the present disclosure provides a heat dissipation element manufactured by using the foregoing method.

A fourth aspect of the present disclosure provides an IGBT module. The IGBT module includes an IGBT circuit board and the heat dissipation element described above.

The present disclosure is further described below by using embodiments, but the present disclosure is not limited thereto.

### Embodiment 1

This embodiment is used to describe a method for manufacturing a heat dissipation element.

One silicon carbide porous skeleton 12 having a thickness of 4.5 mm, a length of 215 mm, and a width of 110 mm, three alumina ceramic insulating plates 2 having a thickness of 0.38 mm, a length of 67 mm, and a width of 61 mm, and three copper layers 6 having a thickness of 0.3 mm, a length of 67 mm, and a width of 61 mm are mounted into a mold 11, a first slot 8 of 0.05 mm exists between the silicon carbide porous skeleton 12 and the ceramic insulating plates 2, and a second slot 9 of 0.05 mm exists between the ceramic insulating plates 2 and the copper layer 6. The three ceramic insulating plates 2 are placed side by side above the silicon carbide porous skeleton 12, and distances between the three ceramic insulating plates 2 are 6.9 mm. The three copper layers 6 are respectively located right above the two ceramic insulating plates 2.

A third slot 10 is further provided between a wall of the mold 11 and the silicon carbide porous skeleton 12, and is used to form a heat dissipation column 5. The third slot 10 is comb-tooth-shaped, and the tooth-shaped protrusion having a length of 8 mm is used to form the heat dissipation column 5. An interval between each two consecutive tooth-shaped protrusions is 0.8 mm.

The mold 11 is preheated to have a temperature of 600°C. Molten aluminum liquid of 700°C is added into the mold 11. Vacuum pumping is performed until a pressure inside the mold 11 is 80 Pa, and then pressurizing is performed until the pressure is 7 MPa. After the aluminum liquid is cooled to be of a room temperature and shaped, demolding is performed. The silicon carbide porous skeleton 12 and the aluminum bonded to the surface and the interior of the silicon carbide porous skeleton 12 form an aluminum silicon carbon heat dissipation body 1.

A part of aluminum metal in the first slot 8 and the second slot 9 is removed by etching after a film is pasted, so that remaining aluminum metal in the first slot 8 forms a first aluminum layer 3 having a thickness of 0.05 mm, and remaining aluminum metal in the second slot 9 forms a second aluminum layer 4 having a thickness of 0.05 mm. In addition, the ceramic insulating plate 2 isolates the second aluminum layer 4 from the first aluminum layer 3 and the aluminum silicon carbon heat dissipation body 1.

The heat dissipation element described in this embodiment is obtained after etching is completed.

### Embodiment 2

This embodiment is used to describe a method for manufacturing a heat dissipation element.

One silicon carbide porous skeleton 12 having a thickness of 4.5 mm, a length of 215 mm, and a width of 110 mm, one aluminum nitride ceramic insulating plate 2 having a thickness of 0.63 mm, a length of 207 mm, and a width of 77 mm, and three copper layers 6 having a thickness of 0.3 mm, a length of 65 mm, and a width of 64 mm are mounted into a mold 11. There is an interval of 5 mm between the copper layers 6. In addition, a first slot 8 of 0.05 mm exists between the silicon carbide porous skeleton 12 and the ceramic insulating plates 2, and a second slot 9 of 0.05 mm exists between the ceramic insulating plates 2 and the copper layer 6.

A third slot 10 is further provided between a wall of the mold 11 and the silicon carbide porous skeleton 12, and is used to form a heat dissipation column 5. The third slot 10 is comb-tooth-shaped, and the tooth-shaped protrusion having a length of 8 mm is used to form the heat dissipation column 5. An interval between each two consecutive tooth-shaped protrusions is 0.8 mm.

The mold 11 is preheated to have a temperature of 600°C. Molten aluminum liquid of 700°C is added into the mold 11. Vacuum pumping is performed until a pressure inside the mold 11 is 80 Pa, and then pressurizing is performed until the pressure is 7 MPa. After the aluminum liquid is cooled to be of a room temperature and shaped, demolding is performed. The silicon carbide porous skeleton 12 and the aluminum bonded to the surface and the interior of the silicon carbide porous skeleton 12 form an aluminum silicon carbon heat dissipation body 1.

A part of aluminum metal in the first slot 8 and the second slot 9 is removed by etching after a film is pasted, so that remaining aluminum metal in the first slot 8 forms a first aluminum layer 3 having a thickness of 0.05 mm, and remaining aluminum metal in the second slot 9 forms three second aluminum layers 4 having a thickness of 0.05 mm. There is an interval of 5 mm between the second aluminum layers 4. In addition, the ceramic insulating plate 2 isolates the second aluminum layers 4 from the first aluminum layer 3 and the aluminum silicon carbon heat dissipation body 1.

The heat dissipation element described in this embodiment is obtained after etching is completed.

### Embodiment 3

This embodiment is used to describe a method for manufacturing a heat dissipation element.

One silicon carbide porous skeleton 12 having a thickness of 4.5 mm, three toughened alumina ceramic insulating plates 2 having a thickness of 0.32 mm, a length of 67 mm, and a width of 61 mm, and three copper layers 6 having a thickness of 0.3 mm, a length of 65 mm, and a width of 59 mm are mounted into a mold 11. The silicon carbide porous skeleton 12 has a length of 210 mm and a width of 110 mm, and three side-by-side grooves 7 having a depth of 0.72 mm, a length of 67 mm, and a width of 61 mm are provided on the silicon carbide porous skeleton 12 by using computer numerical control (CNC) machine tools. There is an interval of 6.9 mm between two of the grooves 7. The ceramic insulating plates 2 and the copper layers 6 are placed inside the grooves 7. The three copper layers 6 are respectively located right above the three ceramic insulating plates 2. In addition, a first slot 8 of 0.05 mm exists between a groove bottom of the silicon carbide porous skeleton 12 and the ceramic insulating plate 2, and a second slot 9 of 0.05 mm exists between the ceramic insulating plate 2 and the copper layer 6.

A third slot 10 is further provided between a wall of the mold 11 and the silicon carbide porous skeleton 12, and is used to form a heat dissipation column 5. The third slot 10 is comb-tooth-shaped, and the tooth-shaped protrusion having a length of 8 mm is used to form the heat dissipation column 5. An interval between each two consecutive tooth-shaped protrusions is 0.8 mm.

The mold 11 is preheated to have a temperature of 600°C. Molten aluminum liquid of 700°C is added into the mold 11. Vacuum pumping is performed until a pressure inside the mold 11 is 80 Pa, and then pressurizing is performed until the pressure is 7 MPa. After the aluminum liquid is cooled to be of a room temperature and shaped, demolding is performed. The silicon carbide porous skeleton 12 and the aluminum bonded to the surface and the interior of the silicon carbide porous skeleton 12 form an aluminum silicon carbon heat dissipation body 1.

A part of aluminum metal in the second slot 9 is removed by etching after a film is pasted, so that aluminum metal in the first slot 8 forms a first aluminum layer 3 having a thickness of 0.05 mm, and remaining aluminum metal in the second slot 9 forms a second aluminum layer 4 having a thickness of 0.05 mm. The second aluminum layer 4 and the first aluminum layer 3 are isolated by the ceramic insulating plate 2, and the second aluminum layer 4 and the aluminum silicon carbon heat dissipation body 1 are isolated. A slot of 1 mm exists between each of the second aluminum layer 4 and the copper layers 6 and an edge of the groove 7.

The heat dissipation element described in this embodiment is obtained after etching is completed.

### Comparative Example 1

Silicon carbide particles and aluminum powder are mixed up and then are subject to cold press molding, hot pressing, annealing, and heat preservation to manufacture an aluminum silicon carbon heat dissipation body.

A ceramic-coated aluminum copper heat conductor is preheated at a temperature of 185°C in hydrogen by using a solder of SnPbAg, and is welded to the aluminum silicon carbon heat dissipation body at a temperature of 265°C. The ceramic-coated aluminum copper heat conductor includes an alumina ceramic insulating plate having a thickness of 0.32 mm, a first copper sheet having a thickness of 0.3 mm, and a second copper sheet having a thickness of 0.3 mm. The first copper sheet and the second copper sheet are oxidatively welded on two opposite surfaces of the ceramic insulating plate. A heat dissipation element of this comparative example is manufactured.

### Test Embodiment 1

A heat-cold cycling test is performed on heat dissipation elements obtained in Embodiments 1 to 3 and Comparative Example 1.

The obtained heat dissipation elements are put into an ice-water mixture. After 30 minutes, the heat dissipation elements are taken out from the ice-water mixture (continuously adding ice cubes and keeping a 0°C environment). After being placed under a room temperature for 10 minutes, the heat dissipation elements are put into an oven of 150°C. After being kept in 150°C for 30 minutes, the heat dissipation elements are taken out from the oven. After being placed at a room temperature for 10 minutes, the IGBT is put into the ice-water mixture (continuously adding ice cubes and keeping a 0°C environment) again by using a heat dissipation bottom plate. The foregoing process is a cycle. 20 heat dissipation elements in each group are separately subject to a performance measurement in coldness and heat impact tolerance. For every 20 cycles, a status (an appearance inspection, for example, a crack and a falling-off situation) of an aluminum layer of a to-be-measured sample is observed once. When the aluminum layer of the to-be-measured sample has an obvious crack and a falling-off tendency, the test for the to-be-measured sample is stopped. A quantity of times for which the to-be-measured sample has gone through the foregoing cycle so far is recorded, and an average of quantities of times for which the 20 to-be-measured heat dissipation elements in each group have gone through the cycle in the test is calculated. Measurement results of the foregoing heat dissipation elements of each group are shown in Table 1.

**Table 1**

| | Appearance after 100 cycles | Quantity of times of coldness and heat impact tolerance |
|---|---|---|
| Embodiment 1 | Good | 200 |
| Embodiment 2 | Good | 1000 |
| Embodiment 3 | Good | 500 |
| Comparative Example 1 | A crack appears in a line slot | 100 |

It can be learned through comparison between Embodiments 1 to 3 and Comparative Example 1 in Table 1 that, the heat dissipation element manufactured in the present disclosure has more excellent performance in coldness and heat impact tolerance, and has higher connection strength.

Exemplary implementations of the present disclosure are described above in detail with reference to the accompanying drawings. However, the present disclosure is not limited to specific details of the foregoing implementations. In the scope of the technical concept of the present disclosure, various simple variations may be made to the technical solutions of the present disclosure. These simple variations all fall within the protection scope of the present disclosure.

In addition, it should be noted that the specific technical features described in the foregoing specific implementations may be combined in any appropriate manner if they are not contradictory. To avoid unnecessary repetition, various possible combination manners are not described again in the present disclosure.

In addition, various different implementations of the present disclosure may be randomly combined. The combinations should also be considered as the content disclosed in the present disclosure provided that the combinations do not depart from the idea of the present disclosure.

## Claims

1. A heat dissipation element, wherein the heat dissipation element comprises a heat conductor and a heat dissipation body, the heat conductor is a ceramic-coated aluminum copper heat conductor; the heat dissipation body is an aluminum silicon carbon heat dissipation body (1); the ceramic-coated aluminum copper heat conductor comprises a ceramic insulating plate (2), a copper layer (6), a first aluminum layer (3) and a second aluminum layer (4), the first aluminum layer (3) and the second aluminum layer (4) are located on two opposite surfaces of the ceramic insulating plate (2), the first aluminum layer (3) and the second aluminum layer (4) are isolated by the ceramic insulating plate (2), and the copper layer (6) is bonded to the ceramic insulating plate (2) by the second aluminum layer (4) that is integrally formed through aluminizing; and the ceramic insulating plate (2) is bonded to the aluminum silicon carbon heat dissipation body (1) by the first aluminum layer (3) that is integrally formed through aluminizing.

2. The heat dissipation element according to claim 1, wherein the ceramic insulating plate (2) is selected form an alumina ceramic plate, a toughened alumina ceramic plate, an aluminum nitride ceramic plate, or a silicon nitride ceramic plate.

3. The heat dissipation element according to claim 1 or 2, wherein there are at least two ceramic-coated aluminum copper heat conductors disposed at an interval, and each of the ceramic-coated aluminum copper heat conductors is bonded to the aluminum silicon carbon heat dissipation body (1) by using the first aluminum layer (3) that is integrally formed through aluminizing.

4. The heat dissipation element according to any one of claims 1 to 3, wherein the aluminum silicon carbon heat dissipation body (1) is a silicon carbide porous skeleton (12) of which at least the surface contains aluminum.

5. The heat dissipation element according to claim 4, wherein the aluminum is bonded to the surface of the silicon carbide porous skeleton (12) through aluminizing in an integral forming manner.

6. The heat dissipation element according to any one of claims 1 to 5, wherein the first aluminum layer (3) and the second aluminum layer (4) are pure aluminum layers and/or aluminum alloy layers.

7. The heat dissipation element according to any one of claims 1 to 6, wherein a thickness of the first aluminum layer (3) is 0.02 to 0.15 mm, a thickness of the ceramic insulating plate (2) is 0.25 to 1 mm, a thickness of the second aluminum layer (4) is 0.02 to 0.15 mm, and a thickness of the copper layer (6) is 0.2 to 0.6 mm.

8. The heat dissipation element according to claim 1, wherein a surface of the aluminum silicon carbon heat dissipation body (1) that is connected to the first aluminum layer (3) is a flat surface.

9. The heat dissipation element according to claim 1, wherein the aluminum silicon carbon heat dissipation body (1) is provided with one or more grooves (7); and the ceramic-coated aluminum copper heat conductor is embedded into the groove (7).

10. The heat dissipation element according to claim 9, wherein the ceramic-coated aluminum copper heat conductor is embedded into the groove (7), so that an upper surface of the copper layer (6) is flush with an upper surface of the aluminum silicon carbon heat dissipation body (1).

11. The heat dissipation element according to any one of claims 1 to 10, wherein the aluminum silicon carbon heat dissipation body (1) is further provided with at least one heat dissipation column (5); one end of the heat dissipation column (5) is fixedly connected to the aluminum silicon carbon heat dissipation body (1), and the other end of the heat dissipation column (5) is a free end; and the heat dissipation column (5) is disposed on a surface, opposite to one side of the ceramic-coated aluminum copper heat conductor, of the aluminum silicon carbon heat dissipation body (1).

12. The heat dissipation element according to claim 11, wherein the heat dissipation column (5) is at least one of an aluminum column, an aluminum alloy column, and an aluminum-coated copper column.

13. The heat dissipation element according to claim 11 or 12, wherein the heat dissipation column (5) is connected to the aluminum silicon carbon heat dissipation body (1) through aluminizing in an integral forming manner.

14. A method for manufacturing a heat dissipation element, wherein the method comprises the following steps:
S1. mounting a silicon carbide porous skeleton (12), a ceramic insulating plate (2), and a copper layer (6) into a mold (11), and enabling a first slot (8) to exist between the silicon carbide porous skeleton (12) and the ceramic insulating plate (2), and a second slot (9) to exist between the ceramic insulating plate (2) and the copper layer (6);
S2. under pressure casting infiltration conditions, adding molten aluminum liquid into the preheated mold (11), filling, with the molten aluminum liquid, the first slot (8), the second slot (9), and the silicon carbide porous skeleton (12), performing operations of vacuum pumping and pressurizing, and then performing cooling and demolding; and
S3. forming an aluminum silicon carbon heat dissipation body (1) after at least the surface of the silicon carbide porous skeleton (12) is filled with aluminum, and removing a part of aluminum metal in the first slot (8) and the second slot (9) by etching, to enable remaining aluminum metal in the first slot (8) to form a first aluminum layer (3) and remaining aluminum metal in the second slot (9) to form a second aluminum layer (4);
alternatively, removing a part of aluminum metal in the second slot (9) by etching, to enable remaining aluminum metal in the second slot (9) to form a second aluminum layer (4).

15. The method according to claim 14, wherein the pressure casting infiltration conditions comprise: a temperature of the preheating is 500 to 700°C, a temperature of the molten aluminum liquid is 500 to 700°C, a pressure of the vacuum pumping is 50 to 100 Pa, a pressure of the pressurizing is 4 to 10 MPa, and the molten aluminum liquid is pure aluminum or aluminum alloy.

16. The method according to claim 14 or 15, wherein at least one column-shaped recess (10) protruding outward is formed on an inner surface of the mold (11), and the column-shaped recess (10) is suitable for forming at least one heat dissipation column (5) connected to the silicon carbide porous skeleton (12).

17. The method according to claim 14, wherein relative to the one aluminum silicon carbon heat dissipation body (1), at least two ceramic insulating plates (2) are disposed; and the at least two ceramic insulating plates (2) are spaced apart from each other.

18. The method according to claim 14, wherein a surface of the aluminum silicon carbon heat dissipation body (1) that is connected to the first aluminum layer (3) is a flat surface.

19. The method according to claim 14, wherein the silicon carbide porous skeleton (12) is provided with at least one groove (7), and the ceramic insulating plate (2) and the copper layer (6) are horizontally disposed inside the groove (7) in sequence, so that there is the first slot (8) between the silicon carbide porous skeleton (12) and the ceramic insulating plate (2), and there is the second slot (9) between the ceramic insulating plate (2) and the copper layer (6).

20. The method according to claim 19, wherein an upper surface of the copper layer (6) and an upper surface of the aluminum silicon carbon heat dissipation body (1) are located on a same plane, and are both in contact with a wall of the mold (11).

21. The method according to any one of claims 14 to 20, wherein the ceramic insulating plate (2) is an alumina ceramic plate, a toughened alumina ceramic plate, an aluminum nitride ceramic plate, or a silicon nitride ceramic plate.

22. The method according to claim 21, wherein a thickness of the first aluminum layer (3) is 0.02 to 0.15 mm, a thickness of the ceramic insulating plate (2) is 0.25 to 1 mm, a thickness of the second aluminum layer (4) is 0.02 to 0.15 mm, and a thickness of the copper layer (6) is 0.2 to 0.6 mm.

23. The method according to claim 14, wherein the etching comprises sequentially performed steps of pasting a film, exposing, developing, corroding, removing the film, and washing.

24. A heat dissipation element manufactured by using the method according to any one of claims 14 to 23.

25. An IGBT module, wherein the IGBT module comprises an IGBT circuit board and a heat dissipation element, and the heat dissipation element is the heat dissipation element according to any one of claims 1 to 13 and 24.
